# DEMANDE DE BREVET EUROPEEN

(11) **EP 3 882 710 A1**
(43) Date de publication de la demande: **22.09.2021**
(21) Numéro de dépôt: 20164297.2
(22) Date de dépôt: 19.03.2020
(51) Int. Cl.: G04B 1/14, G04B 15/14, G04B 17/06, G04B 17/22, G04B 19/04, G04B 19/12, G04B 21/06

(54) **PROCÉDÉ DE FABRICATION D'UN COMPOSANT HORLOGER À BASE DE SILICIUM**

(71) Demandeur: Patek Philippe SA Genève, 1204 Genève (CH)
(72) Inventeur: BUCAILLE, Jean-Luc, 74160 Présilly (FR); JEANNERET, Sylvain, 2013 Colombier (CH)
(74) Mandataire: Micheli & Cie SA

(57) **Abrégé**

L'invention concerne un procédé de fabrication d'un composant horloger selon lequel on réalise à base de silicium une pièce ayant la forme souhaitée du composant horloger et on soumet la pièce à un traitement d'oxydation thermique et de désoxydation pour retirer une épaisseur prédéterminée de silicium afin d'augmenter la résistance mécanique de la pièce. Ce procédé est caractérisé en ce que le traitement d'oxydation thermique et de désoxydation est effectué en plusieurs étapes, chaque étape comprenant une phase d'oxydation thermique suivie d'une phase de désoxydation.

## Description

La présente invention concerne un procédé de fabrication d'un composant horloger à base de silicium, notamment pour montre-bracelet ou montre de poche.

Le silicium est un matériau très apprécié dans l'horlogerie mécanique pour ses propriétés avantageuses, notamment sa faible densité, sa grande résistance à la corrosion, son caractère amagnétique et son aptitude à être usiné par des techniques de micro-fabrication. On l'utilise ainsi pour fabriquer des ressorts spiraux, des balanciers, des oscillateurs à guidage flexible, des ancres d'échappement et des roues d'échappement.

Le silicium présente néanmoins l'inconvénient d'une faible résistance mécanique, inconvénient qui est aggravé par le mode de gravure généralement utilisé pour son usinage, la gravure ionique réactive profonde dite DRIE, qui laisse des arêtes vives et crée des défauts de planéité en forme de vaguelettes (appelés « scalloping » en anglais) sur les flancs de la pièce. Cette faible résistance mécanique est problématique pour la manipulation des composants lors de leur montage dans un mouvement ou en cas de chocs subis par la montre. Les composants peuvent en effet facilement se rompre. Pour répondre à ce problème, on renforce généralement les composants horlogers en silicium par un revêtement d'oxyde de silicium d'épaisseur très supérieure à celle de l'oxyde natif, comme décrit dans la demande de brevet WO 2007/000271. Ce revêtement est généralement laissé sur le composant final mais, selon l'enseignement de la demande de brevet EP 2277822, il peut être éliminé sans affecter sensiblement la résistance mécanique.

Dans le cas des ressorts, la résistance mécanique doit en outre être suffisante pour que le composant puisse se déformer élastiquement sans rupture pendant son fonctionnement pour exercer sa fonction. Pour un ressort spiral destiné à équiper un balancier ou pour le guidage flexible d'un oscillateur sans pivots, les contraintes en fonctionnement sont relativement peu élevées, de l'ordre de quelques centaines de MPa au maximum, si bien que la résistance mécanique apportée par la couche d'oxyde de silicium peut en théorie suffire. Cependant, compte tenu des fréquences d'oscillation en fonctionnement (4 Hz, 10 Hz voire 50 Hz), le nombre de cycles est élevé, ce qui peut entraîner des risques de rupture par fatigue. Pour d'autres ressorts comme les ressorts moteurs, notamment ressorts de barillet, ou certains ressorts de marteau ou de bascule, les contraintes subies pendant leur fonctionnement sont beaucoup plus élevées, de l'ordre de quelques GPa, et imposent de choisir des matériaux de fabrication à haute limite élastique tels que des aciers, des alliages nickel-phosphore, le Nivaflex® (alliage à base de Co, Ni, Cr et Fe ayant une limite élastique d'environ 3,7 GPa), des verres métalliques (cf. brevets CH 698962 et CH 704391) ou des matériaux composites métal/diamant ou métalloïde/diamant (cf. brevet CH 706020 de la demanderesse).

Depuis la demande de brevet WO 2019/202378 de la demanderesse, il est possible de réaliser des ressorts horlogers en silicium capables de résister à des contraintes particulièrement élevées et présentant en outre une grande résistance à la fatigue. Le procédé décrit dans cette demande de brevet comprend une succession d'étapes qui améliore considérablement la qualité des ressorts en silicium, notamment l'état de surface et l'arrondi des arêtes, ce qui se traduit par une contrainte de rupture moyenne proche de 5 GPa. Selon ce procédé, les ressorts sont successivement oxydés thermiquement, désoxydés, soumis à une opération de recuit dans une atmosphère réductrice et recouverts d'une couche d'oxyde de silicium, l'opération de recuit pouvant en variante être effectuée avant l'oxydation thermique. Ce procédé présente toutefois des inconvénients : l'étape de recuit est coûteuse à mettre en œuvre et nécessite l'emploi d'une machine encombrante.

La présente invention vise à remédier à ces inconvénients et plus généralement à permettre la fabrication, à coût modéré, d'un ressort ou autre composant horloger ayant une grande résistance mécanique.

A cette fin, il est proposé un procédé de fabrication d'un composant horloger selon lequel on réalise à base de silicium une pièce ayant la forme souhaitée du composant horloger et on soumet la pièce à un traitement d'oxydation thermique et de désoxydation pour retirer une épaisseur prédéterminée de silicium afin d'augmenter la résistance mécanique de la pièce, caractérisé en ce que ledit traitement est effectué en plusieurs étapes, chaque étape comprenant une phase d'oxydation thermique suivie d'une phase de désoxydation.

Lorsqu'une pièce en silicium est oxydée thermiquement, la couche d'oxyde de silicium qui apparaît à sa surface se forme en consommant du silicium sur une profondeur correspondant à 44% de son épaisseur. Après avoir éliminé la couche d'oxyde de silicium, il reste donc une pièce en silicium de taille réduite, dont les défauts de surface (vaguelettes, fissures, brèches, etc.) constituant des amorces de rupture ont été atténués voire supprimés.

Cet effet est connu dans la technique antérieure et a été décrit par exemple dans la demande de brevet EP 2277822 mentionnée plus haut. La demanderesse a cependant constaté de manière surprenante que si l'on effectue la séquence d'oxydation - désoxydation en plusieurs fois, avec à chaque fois une phase d'oxydation thermique suivie d'une phase de désoxydation, la résistance mécanique du composant est très nettement améliorée.

Il est certes connu dans la technique antérieure de mettre en œuvre plusieurs fois une séquence d'oxydation - désoxydation (cf. EP 3181938, WO 2019/166922, WO 2019/180596, EP 3416001) mais il s'agit toujours de procédés destinés à régler la raideur d'un spiral ou la fréquence d'un oscillateur et la répétition de la séquence d'oxydation - désoxydation n'a jamais pour but d'augmenter la résistance mécanique. De plus, dans ces procédés, les oxydations et désoxydations ne permettent pas de retirer une épaisseur prédéterminée de silicium. En effet, chaque nouvelle mise en œuvre de la séquence d'oxydation - désoxydation est précédée d'une étape de mesure de raideur ou de fréquence dont dépend l'épaisseur de silicium à retirer pendant ladite séquence. L'épaisseur totale de silicium à retirer ne peut donc pas être déterminée à l'avance, contrairement à la présente invention où cette épaisseur n'est liée à aucune mesure de raideur ou de fréquence du composant horloger.

Lorsque le composant horloger est un spiral ou un oscillateur à pivot flexible, le traitement d'oxydation thermique et de désoxydation du procédé selon l'invention peut être suivi d'étapes visant à régler la raideur ou la fréquence du composant par une ou plusieurs séquences d'oxydation - désoxydation précédées chacune d'une étape de mesure de la raideur ou de la fréquence et d'une étape de calcul de l'épaisseur de silicium à retirer, comme décrit par exemple dans les documents EP 3181938 et EP 3416001.

Le réglage de la raideur ou de la fréquence peut en variante être effectué avant le traitement d'oxydation thermique et de désoxydation selon l'invention. Compte tenu de l'épaisseur prédéterminée de silicium enlevée par le traitement d'oxydation thermique et de désoxydation selon l'invention, on sait en effet à quelle raideur ou fréquence il faut régler le composant pour obtenir une raideur ou fréquence souhaitée après le traitement.

Il est également possible de compléter le procédé selon l'invention par la formation d'une couche finale sur la pièce, par exemple une couche d'oxyde de silicium, une couche améliorant les propriétés tribologiques, une couche formant une barrière contre l'oxygène ou une couche servant à contenir d'éventuels débris, même si, en ce qui concerne la couche d'oxyde de silicium, celle-ci est rendue superflue par la répétition des phases d'oxydation thermique et de désoxydation, comme il sera démontré dans la suite.

D'autres caractéristiques et avantages de la présente invention apparaîtront à la lecture de la description détaillée suivante faite en référence aux dessins annexés dans lesquels :
- la figure 1 est un schéma montrant les différentes étapes d'un procédé de fabrication selon un mode de réalisation particulier de l'invention ;
- les figures 2 et 3 sont des graphiques montrant par des boîtes à moustaches des valeurs de contrainte de rupture apparente obtenues pour plusieurs lots différents de pièces.

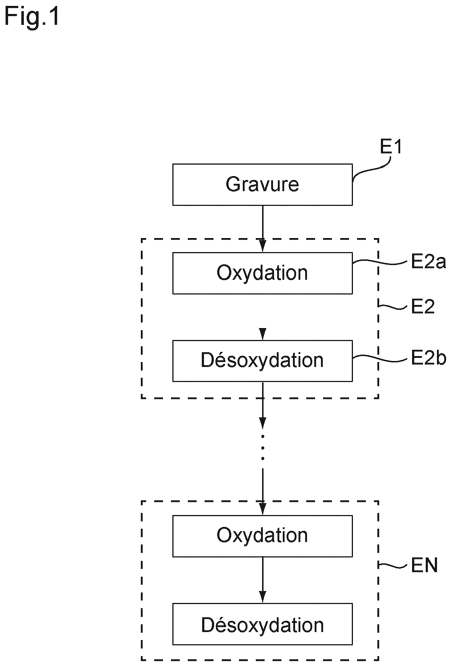

En référence à la figure 1, un mode de réalisation particulier du procédé de fabrication d'un composant horloger à base de silicium selon l'invention comprend des étapes E1 à EN.

Une première étape E1 consiste à graver dans une plaquette de silicium, de préférence par gravure ionique réactive profonde (DRIE), une pièce ayant la forme souhaitée du composant horloger.

Le silicium peut être monocristallin, polycristallin ou amorphe. Pour une isotropie de l'ensemble des caractéristiques physiques, le silicium polycristallin peut être préféré. Le silicium utilisé dans l'invention peut en outre être dopé ou non. A la place du silicium proprement dit, la pièce peut être réalisée dans un matériau composite comprenant des couches épaisses de silicium séparées par une ou plusieurs couches minces intermédiaires d'oxyde de silicium, par gravure dans un substrat silicium sur isolant (substrat SOI).

Une deuxième étape E2 du procédé se divise en deux phases. Dans une première phase E2a, la pièce est oxydée thermiquement, typiquement à une température comprise entre 600°C et 1300°C, de préférence entre 900°C et 1200°C, de préférence encore entre 950°C et 1150°C, dans une atmosphère oxydante comprenant par exemple du gaz de dioxygène ou de la vapeur d'eau. Cette oxydation est mise en œuvre jusqu'à obtenir sur la surface de la pièce une couche d'oxyde de silicium (SiO₂) d'épaisseur prédéterminée typiquement comprise entre 0,5 µm et 2 µm et de préférence égale à environ 1 µm. Cette couche d'oxyde de silicium se forme par croissance en consommant du silicium, ce qui fait reculer l'interface entre le silicium et l'oxyde de silicium et atténue les défauts de surface du silicium. Dans une deuxième phase E2b de l'étape E2, la pièce est désoxydée, autrement dit la couche d'oxyde de silicium est éliminée, par exemple par gravure humide, gravure en phase vapeur ou gravure sèche, de préférence par gravure humide à l'acide fluorhydrique.

La deuxième étape E2 est ensuite répétée au moins une fois, avec des paramètres qui peuvent être constants ou qui peuvent varier d'une séquence d'oxydation - désoxydation à une autre. De préférence, toutefois, l'épaisseur d'oxyde de silicium formée à chaque oxydation est la même. A la fin de la dernière étape d'oxydation - désoxydation, EN, une épaisseur totale de silicium a été retirée de la pièce, dont la valeur est déterminée par les propriétés physiques du silicium et de l'oxyde de silicium et les paramètres du traitement thermique. La connaissance de ces propriétés et paramètres permet de calculer les dimensions de la pièce à graver à l'étape E1 pour obtenir les dimensions voulues à l'issue de l'étape EN.

Typiquement, ladite pièce fait partie d'un lot de pièces identiques réalisées simultanément dans une même plaquette de silicium. Après l'étape EN, la pièce et les autres pièces du lot sont détachées de la plaquette.

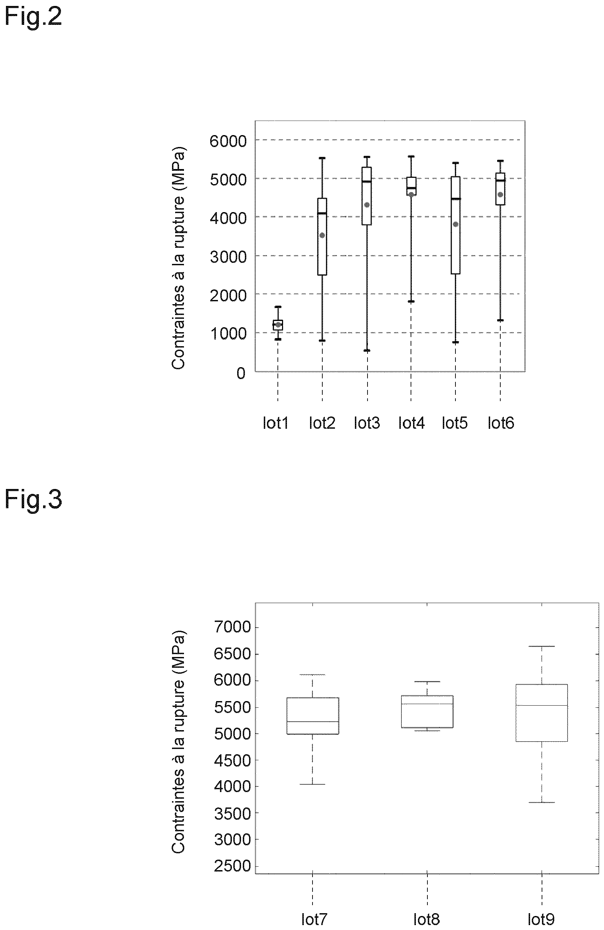

La figure 2 montre les résultats remarquables obtenus avec le procédé selon l'invention. A titre de comparaison, on a représenté à la figure 2 la contrainte de rupture apparente mesurée sur des éprouvettes de flexion trois points identiques réparties en six lots différents :
- Lot 1 : des éprouvettes fabriquées uniquement par DRIE (étape E1 uniquement). Ce lot est le lot de référence.
- Lot 2 : des éprouvettes fabriquées par DRIE et ayant subi une oxydation thermique qui les a revêtues d'une couche d'oxyde de silicium de 1 µm d'épaisseur puis une désoxydation qui a éliminé cette couche d'oxyde (étapes E1 et E2 uniquement).
- Lot 3 : des éprouvettes fabriquées par DRIE et ayant subi une oxydation thermique qui les a revêtues d'une couche d'oxyde de silicium de 2 µm d'épaisseur puis une désoxydation qui a éliminé cette couche d'oxyde (étapes E1 et E2 uniquement).
- Lot 4 : des éprouvettes fabriquées selon le procédé selon l'invention (étapes E1, E2 et E3), avec deux étapes d'oxydation - désoxydation, l'oxydation dans chacune de ces étapes ayant conduit à la formation d'une couche d'oxyde de silicium de 1 µm d'épaisseur.
- Lot 5 : des éprouvettes fabriquées par DRIE et ayant subi une oxydation thermique qui les a revêtues d'une couche d'oxyde de silicium de 3 µm d'épaisseur puis une désoxydation qui a éliminé cette couche d'oxyde (étapes E1 et E2 uniquement).
- Lot 6 : des éprouvettes fabriquées selon le procédé selon l'invention (étapes E1 à E4), avec trois étapes d'oxydation - désoxydation, l'oxydation dans chacune de ces étapes ayant conduit à la formation d'une couche d'oxyde de silicium de 1 µm d'épaisseur.

Toutes ces éprouvettes sont fabriquées à partir de la même plaquette de silicium.

Dans le graphique de la figure 2, les boîtes rectangulaires représentent 50% des pièces et les deux segments de part et d'autre de chaque boîte représentent chacun 25% des pièces. Le trait horizontal à l'intérieur de chaque boîte représente la valeur médiane. Le point représente la valeur moyenne.

Il est intéressant de constater que la valeur moyenne ainsi que l'extrémité inférieure de la boîte, qui correspond à la valeur de contrainte de rupture apparente minimale pour une population comptant 75% des pièces, sont bien plus élevées pour les lots 4 et 6 fabriqués selon l'invention que pour les lots 3 et 5 respectivement. L'invention met donc en évidence que pour une même épaisseur de silicium retirée, il est préférable de réaliser l'oxydation - désoxydation en plusieurs fois même si cela implique la mise en œuvre de plusieurs opérations de désoxydation, l'avantage obtenu en termes de résistance mécanique l'emportant largement sur cet inconvénient.

Les étapes E3 à EN, c'est-à-dire la répétition de l'étape E2, remplacent avantageusement les étapes de recuit et de formation d'une couche finale d'oxyde de silicium du procédé décrit dans la demande de brevet WO 2019/202378 et simplifient donc grandement la fabrication du composant horloger. Le procédé selon l'invention peut être complété par une étape consistant à revêtir le composant horloger d'une couche finale d'oxyde de silicium mais le gain de résistance mécanique apporté par une telle couche est assez limité voire inexistant par rapport à l'inconvénient que présente la mise en œuvre d'une étape d'oxydation supplémentaire. Ceci est illustré par le graphique de la figure 3 sur lequel on peut voir que des éprouvettes de flexion trois points réalisées par DRIE et ayant subi deux séquences d'oxydation - désoxydation avec la formation d'une épaisseur de 1 µm d'oxyde à chaque oxydation (lot 7) ont statistiquement une résistance mécanique voisine de celle d'éprouvettes obtenues et traitées de la même manière, et issues de la même plaquette de silicium, mais en plus recouvertes d'une couche finale de 1 µm d'oxyde thermique (lot 8) ou d'une couche finale de 3 µm d'oxyde thermique (lot 9).

Par conséquent, au lieu de revêtir le composant horloger d'une couche finale d'oxyde de silicium, on peut laisser le composant final se recouvrir naturellement d'une mince couche d'oxyde natif. En variante, on peut former sur le composant horloger une couche d'un matériau ayant de bonnes propriétés tribologiques, par exemple du carbone cristallisé sous forme de diamant (DLC) ou des nanotubes de carbone, une couche formant une barrière contre l'oxygène ou une couche, par exemple en parylène, servant à contenir les débris en cas de rupture du composant.

L'invention présente un intérêt particulier pour les composants horlogers élastiques ou à parties élastiques qui doivent résister pendant leur fonctionnement ou leur montage à de fortes contraintes de déformation, tels que les ressorts moteurs (notamment ressorts de barillet), certains ressorts de rappel (notamment des ressorts de marteau, de levier, de bascule, des ressorts cliquets ou des ressorts sautoirs), des composants horlogers à guidage flexible (notamment des oscillateurs, leviers ou bascules) ou des composants horlogers (notamment des roues, viroles, ancres ou chevilles de plateau) comprenant des parties élastiques servant au montage de ces composants sur des organes de support tels que des axes. Une autre application avantageuse sont les ressorts horlogers dont le nombre de cycles de fonctionnement est élevé et qui sont donc sujets à des ruptures par fatigue, comme les spiraux et lames des oscillateurs à guidage flexible. Mais l'invention s'applique aussi à des composants horlogers rigides susceptibles de subir des chocs pendant leur fonctionnement, leur manipulation ou leur montage, en particulier à des balanciers, leviers, bascules, ancres, marteaux, râteaux, doigts, roues, viroles, axes, chevilles de plateau, éléments de bâti (notamment ponts), cadrans ou aiguilles indicatrices.

## Revendications

1. Procédé de fabrication d'un composant horloger selon lequel on réalise à base de silicium une pièce ayant la forme souhaitée du composant horloger et on soumet la pièce à un traitement d'oxydation thermique et de désoxydation pour retirer une épaisseur prédéterminée de silicium afin d'augmenter la résistance mécanique de la pièce, **caractérisé en ce que** ledit traitement est effectué en plusieurs étapes, chaque étape comprenant une phase d'oxydation thermique suivie d'une phase de désoxydation.

2. Procédé selon la revendication 1, **caractérisé en ce que** l'opération de réalisation de la pièce comprend une opération de gravure d'une plaquette à base de silicium.

3. Procédé selon la revendication 2, **caractérisé en ce que** la gravure est une gravure ionique réactive profonde.

4. Procédé selon l'une quelconque des revendications 1 à 3, **caractérisé en ce que** chaque phase d'oxydation thermique est effectuée à une température comprise entre 600°C et 1300°C, de préférence entre 900°C et 1200°C, de préférence entre 950°C et 1150°C.

5. Procédé selon l'une quelconque des revendications 1 à 4, **caractérisé en ce que** chaque phase de désoxydation comprend une opération de gravure, par exemple une opération de gravure humide, de gravure en phase vapeur ou de gravure sèche.

6. Procédé selon l'une quelconque des revendications 1 à 5, **caractérisé en ce que** chaque phase d'oxydation thermique conduit à la formation d'une couche d'oxyde de silicium d'épaisseur comprise entre 0,5 et 2 µm et de préférence égale à environ 1 µm.

7. Procédé selon l'une quelconque des revendications 1 à 6, **caractérisé en ce que** le traitement d'oxydation thermique et de désoxydation n'est pas suivi d'une étape de formation d'une couche finale d'oxyde de silicium.

8. Procédé selon l'une quelconque des revendications 1 à 7, **caractérisé en ce que** le composant horloger est élastique ou comprend au moins une partie élastique.

9. Procédé selon l'une quelconque des revendications 1 à 8, **caractérisé en ce que** le composant horloger est un ressort moteur, un ressort de marteau, un ressort de levier, un ressort de bascule, un ressort de râteau, un ressort cliquet, un ressort sautoir, un ressort spiral, un composant horloger comprenant un guidage flexible ou un composant horloger comprenant une ou des parties élastiques servant à son montage sur un organe de support tel qu'un axe.

10. Procédé selon l'une quelconque des revendications 1 à 8, **caractérisé en ce que** le composant horloger est un balancier, un levier, une bascule, une ancre, un marteau, un râteau, un doigt, une roue, une virole, un axe, une cheville de plateau, un élément de bâti, un cadran ou une aiguille indicatrice.

11. Composant horloger obtenu par le procédé selon l'une quelconque des revendications 1 à 10.
